# EUROPÄISCHE PATENTSCHRIFT

(11) **EP 3 472 568 B1**
(45) Veröffentlichungstag und Bekanntmachung des Hinweises auf die Patenterteilung: **23.09.2020**
(21) Anmeldenummer: 17730684.2
(22) Anmeldetag: 24.05.2017
(51) Int. Cl.: G01D 5/241, H01B 11/02, G01R 31/08, H01B 7/04, H01B 7/32, G01L 5/22, F16L 11/12

(54) **VORRICHTUNG, VERFAHREN UND VERWENDUNG EINER SENSORLEITUNG ZUR TORSIONSMESSUNG**
ICE, METHOD AND APPLICATION OF A SENSOR WIRE FOR MEASURING TORSION
DISPOSITIF, PROCÉDÉ ET L'APPLICATION D'UN CÂBLE DE DÉTECTEUR POUR LA MESURE DE TORSION

(30) Priorität: 15.06.2016 DE 102016210615
(43) Veröffentlichungstag der Anmeldung: 24.04.2019
(73) Patentinhaber: LEONI Kabel GmbH, 91154 Roth (DE)
(72) Erfinder: JANSSEN, Bernd, 26169 Friesoythe OT Neuscharrel (DE); PÖHMERER, Rainer, 90610 Winkelhaid (DE)
(74) Vertreter: FDST Patentanwälte
(86) Internationale Anmeldenummer: PCT/EP2017/062490
(87) Internationale Veröffentlichungsnummer: WO 2017/215891

(56) Entgegenhaltungen:
- EP-A1- 2 495 733
- EP-A1- 2 746 729
- DE-A1-102007 022 039
- US-A1- 2006 196 252
- US-A1- 2009 236 120

## Beschreibung

Die Erfindung betrifft eine Vorrichtung, eine Versorgungsleitung für eine solche, sowie eine Sensorleitung und ein Verfahren zur Messung der Torsion der Versorgungsleitung.

Eine Versorgungsleitung dient zur Verbindung zweier Maschinenteile und zur Übertragung von Energie, Signalen und/oder Arbeitsmedien zwischen den beiden Maschinenteilen. Die beiden Maschinenteile sind häufig relativ zueinander beweglich, sodass die Versorgungsleitung insbesondere widerkehrenden mechanischen Belastungen ausgesetzt ist, besonders Torsionsbelastungen, aber z.B. auch Biegebelastungen. Besonders hohe Anforderungen bezüglich der Flexibilität einer solchen Versorgungsleitung ergeben sich im Bereich von Robotern, beispielsweise Roboterarmen in der Fertigung. Auch im automotiven Bereich werden Versorgungsleitungen oftmals potentiell stark beansprucht.

Kritisch ist dabei insgesamt, dass die Versorgungsleitung konstruktionsbedingt nur ein bestimmtes Maß an Verformung, insbesondere Torsion, toleriert und bei einer Überbeanspruchung die Gefahr eines Funktionsausfalls besteht. Grundsätzlich ist es möglich, die Versorgungsleitung über eine starre Führungskontur oder eine bewegungslimitierte Mechanik zwangszuführen, d.h. lediglich entlang eines vorbestimmten Pfads zu führen und die Bewegung auf bestimmte Fixpunkte, z.B. Drehpunkte zu beschränken. An diesen Fixpunkten kann dann mittels herkömmlicher Sensoren die Torsionsbelastung gemessen werden. Die mitunter regelmäßige Lageänderung und wiederholte Verformung der Versorgungsleitung ist in den eingangs genannten Einsatzbereichen jedoch besonders komplex und es wird oftmals ein hohes Maß an Variabilität verlangt. Eine Erfassung der Torsionsbelastung bei nicht-zwangsgeführten Versorgungsleitungen ist jedoch mit herkömmlichen Sensoren nicht möglich.

In der US 2006/0196252 A1 ist ein System zur Prognose eines strukturellen Versagens eines Schlauchs beschrieben. Hierzu wird die Kapazität zwischen zwei koaxial angeordneten Leitern gemessen.

In der EP 2 495 733 A1 ist eine elektrische Leitung beschrieben, mit einem Sensorelement, welches zwei Leiter aufweist, zwischen welchen die Kapazität gemessen wird, um eine Zugbelastung auf das Kabel zu erkennen.

In der DE 10 2007 022 039 A1 ein Sensor, mit welchem in Kombination mit einer Zeitdomänenreflektometrie Verformungen oder mechanische Drücke quantifiziert werden. Der Sensor weist ein komprimierbares Isolationsmedium auf, welches sandwischartig zwischen zwei Leiterstreifen angeordnet ist.

In der EP 2 746 729 A1 wird ein Kabel mit mehreren Leitern beschrieben, dessen Verformung durch Messung der Kapazität zwischen den Leitern erkannt wird. Hieraus wird dann ein Steuersignal abgeleitet.

In der US 2009/0236120 A1 wird ein Kabel beschrieben, mit einem ersten und einem zweiten isolierten Leiter und mit einem dielektrischen Band zwischen den beiden Leitern.

Vor diesem Hintergrund ist es eine Aufgabe der Erfindung, eine zuverlässige Überwachung oder Messung der Torsion bei solchen beanspruchten, insbesondere nicht zwangsgeführten Versorgungsleitungen zu ermöglichen. Hierzu soll eine Vorrichtung mit einer Versorgungsleitung angegeben werden, deren Torsion möglichst einfach und flexibel messbar ist und gemessen wird. Die Versorgungsleitung selbst soll dabei möglichst frei beweglich sein. Des Weiteren soll eine Torsionsmessung insbesondere gerade nicht lediglich punktuell erfolgen, sondern unter Berücksichtigung der gesamten Versorgungsleitung. Weiterhin soll eine entsprechende Versorgungsleitung angegeben werden sowie eine Sensorleitung und ein Verfahren zur Messung der Torsion der Versorgungsleitung.

Die Aufgabe wird erfindungsgemäß gelöst durch eine Vorrichtung mit den Merkmalen gemäß Anspruch 1. Weiterhin wird die Aufgabe gelöst durch ein Verfahren mit den Merkmalen gemäß Anspruch 6 sowie durch eine Verwendung mit den Merkmalen gemäß Anspruch 7. Vorteilhafte Ausgestaltungen, Weiterbildungen und Varianten sind Gegenstand der Unteransprüche. Dabei gelten die Ausführungen im Zusammenhang mit der Vorrichtung sinngemäß auch für eine Versorgungsleitung, eine Sensorleitung und das Verfahren sowie umgekehrt.

Die Vorrichtung weist generell zwei Maschinenteile auf, welche relativ zueinander beweglich sind und welche mittels einer Versorgungsleitung miteinander verbunden sind. Die Versorgungsleitung selbst weist üblicherweise eine Anzahl, also ein oder mehrere Versorgungstränge auf, über die das eine der beiden Maschinenteile versorgt wird. Neben den Versorgungssträngen weist die Versorgungsleitung zusätzlich eine Sensorleitung zur Messung der Torsion der Versorgungsleitung auf, d.h. zur Messung einer Verdrehung der Versorgungsachse um eine (Mitten-) Längsachse derselben. Dabei ist die Sensorleitung an eine Messeinheit angeschlossen, welche derart ausgebildet ist, dass ein elektrischer Parameter der Sensorleitung gemessen wird und dass mittels des Parameters auf die Torsion zumindest geschlossen wird. Aus dem Messwert des Parameters wird daher eine Kenngröße für die aktuelle Torsionsbelastung abgeleitet und damit zumindest indirekt die Torsion bestimmt. Dabei wird insbesondere die Torsion der Versorgungsleitung entlang deren insbesondere gesamter Länge zwischen den beiden Maschinenteilen bestimmt.

Der Erfindung liegt insbesondere die Beobachtung zugrunde, dass eine Torsionsmessung herkömmlicherweise lediglich punktuell durch Anbringen eines Torsionssensors möglich ist. Die Versorgungsleitung muss dann beispielsweise zwangsgeführt sein, um lediglich in bestimmter Weise belastet zu werden, sodass eine Messung der Torsion an bestimmten Fixpunkten möglich ist. Alternativ müssen entsprechend viele Sensoren entlang der Versorgungsleitung verteilt angeordnet werden, wodurch die Messung in konstruktiver Hinsicht besonders aufwendig ist. Demgegenüber wurde erkannt, dass sich die elektrischen Eigenschaften einer Leitung mit geeignetem Aufbau bei einer Bewegung und/oder Verformung in messbarer Weise verändern, sodass eine entsprechende Leitung vorteilhaft als Sensorleitung verwendbar ist. Ein wesentlicher Vorteil der Erfindung besteht somit insbesondere darin, dass auf spezielle Torsionssensoren verzichtet wird und stattdessen eine geeignete Sensorleitung als Torsionssensor verwendet wird. D.h. die Sensorleitung ist keine Zuleitung zu einem Sensor, sondern selbst ein Sensor, genauer gesagt ein Torsionssensor. Die Torsion wird daher mittels der Sensorleitung nicht punktuell sondern über größere Längsabschnitte von typischerweise mehreren 10cm bis hin zu mehreren Metern, insbesondere über die gesamte Länge der Sensorleitung, erfasst.

Wesentlich für die Bestimmung der Torsion ist die Messung des elektrischen Parameters der Sensorleitung. Ein Kennzeichen dieses Parameters ist, dass sich dieser in Abhängigkeit einer Torsion der Sensorleitung verändert. Da die Sensorleitung mit der Versorgungsleitung mechanisch gekoppelt ist, ergibt sich aus einer Torsion der Versorgungsleitung auch eine vorzugsweise identische Torsion der Sensorleitung. Diese weist wiederum bestimmte Übertragungseigenschaften auf, welche durch den Parameter charakterisiert sind. Die Änderung des Parameters entspricht somit insbesondere einer Änderung der Übertragungseigenschaften der Sensorleitung, d.h. durch Messung des Parameters erfolgt eine Messung der Übertragungseigenschaften. Zweckmäßigerweise wird daher zur Messung des Parameters ein elektrisches Testsignal an die Sensorleitung angelegt oder in diese eingespeist und die Übertragungseigenschaften anhand der Änderung des Testsignals bestimmt. Dazu ist die Sensorleitung an die Messeinheit angeschlossen, welche ein geeignetes Testsignal bereitstellt und insbesondere dessen Änderung misst. Die Messeinheit misst den Parameter und wertet die Messung vorzugsweise auch aus, z.B. durch Vergleichen mit zuvor gemessenen Werten des Parameters. Mit der Messung des Parameters bestimmt die Messeinheit dann letztendlich die Torsion der Sensorleitung und damit auch die Torsion der Versorgungsleitung.

Das Prinzip der Messung der Torsionsbelastung der Versorgungsleitung beruht daher allgemein darauf, dass durch die Integration der Sensorleitung in die Versorgungsleitung auch die Sensorleitung einer Torsionsbeanspruchung unterliegt, welche zu einer mechanischen Änderung des Aufbaus der Sensorleitung führt, wodurch sich die Übertragungseigenschaften für ein über die Sensorleitung übermitteltes (Sensor-) Signal ändern und dadurch zu einer charakteristischen Änderung des Signals führen. Anhand dieser charakteristischen Änderung des Signals werden dann mittels der Messeinheit Rückschlüsse auf die Torsionsbelastung geschlossen.

Vorzugsweise ist die Sensorleitung mechanisch robust ausgebildet, zur mehrfachen Messung der Torsion, insbesondere einer kritischen Torsion, welche nicht überschritten werden soll. Unter "mechanisch robust" wird insbesondere verstanden, dass die Sensorleitung bei einer Torsionsbeanspruchung nicht bricht. Die Sensorleitung ist demnach gerade nicht als Opferleitung konzipiert, sondern als mechanisch robuste Sensorleitung. Ein wesentlicher Vorteil ist insbesondere, dass die Sensorleitung nicht als schwächstes Glied der Versorgungsleitung ausgelegt werden muss, welches bei einem bestimmten Maß an Belastung zerbricht und dadurch eine bestimmte Torsionsbeanspruchung indiziert. Vielmehr ist die Sensorleitung vorteilhafterweise mehrfach verwendbar, um bestimmte kritische Torsionsbeanspruchungen mehrmals zu erkennen.

Die Sensorleitung wird entlang der Versorgungsleitung angeordnet und ist mit dieser verbunden, sodass die Sensorleitung folglich den gleichen oder zumindest ähnlichen Belastungen unterliegt wie die Versorgungsleitung. Durch Messung des elektrischen Parameters, d.h. einer der elektrischen Eigenschaften der Sensorleitung wird dann auf besonders einfache Weise die Verformung der Sensorleitung selbst und mit dieser auch die Verformung der Versorgungsleitung gemessen. Dabei wird bei der Messung prinzipbedingt der Verlauf der gesamten Sensorleitung berücksichtigt und entsprechend ein langgestreckter und insbesondere durchgängiger Abschnitt der Versorgungsleitung. Vorzugsweise verläuft die Sensorleitung entlang der gesamten Versorgungsleitung, sodass die Torsion derselben insgesamt gemessen wird. Alternativ wird die Torsion jedoch lediglich abschnittsweise gemessen und hierzu die Sensorleitung lediglich abschnittsweise entlang der Versorgungsleitung angebunden.

Die Sensorleitung ist Teil der Versorgungsleitung und mit dieser mechanisch verbunden. Insbesondere bildet Sie mit den einzelnen Versorgungssträngen der Versorgungsleitungen einen Verbund, welcher bevorzugt von einem gemeinsamen Außenmantel umgeben ist.

Mittels der Sensorleitung lassen sich insbesondere Torsionen im Bereich von größer einer vollständigen Umdrehung der Versorgungsleitung um deren Längsachse pro laufendem Meter der Versorgungsleitung bis hin zu 20 Umdrehungen pro Meter messen. Grundsätzlich sind aber auch weniger oder mehr Umdrehungen mit der hier beschriebenen Sensorleitung messbar. Der Messbereich ist dabei vor Allem durch die konkrete Auslegung und Dimensionierung der Sensorleitung bestimmt. Durch entsprechende Anpassung der Sensorleitung ist es somit möglich, die Torsionsmessung optimal auf die vorliegende Anwendung anzupassen.

Die Versorgungsleitung dient vorrangig der Übertragung von Energie, Signalen und/oder Arbeitsmedien zwischen den beiden Maschinenteilen. Die einzelnen Versorgungsstränge der Versorgungsleitung sind daher wahlweise oder in beliebigen, anwendungsabhängigen Kombinationen ein Stromkabel zur Leistungsversorgung des Maschinenteils, ein Datenkabel, ein Schlauch, beispielsweise ein Hydraulik- oder ein Pneumatikschlauch zur Versorgung des Maschinenteils mit einer Hydraulikflüssigkeit, einem Betriebs- oder Schmiermittel, mit einem Gas oder mit Druckluft. Als Versorgungsstränge können weiterhin ein Hybridkabel, ein Kabelbaum verwendet werden. Die Versorgungstränge sind üblicherweise, insbesondere im Bereich der Robotik, von einem Schlauch umgeben und bilden ein Schlauchpaket aus. Die Maschinenteile müssen nicht zwangsweise zusätzlich miteinander gekoppelt sein, können allerdings beispielsweise über ein Gelenk miteinander verbunden sein. Die Maschinenteile sind beispielsweise zwei Teile eines Roboters, z.B. eine Basis und ein relativ hierzu beweglicher Manipulator. Die Versorgungsleitung führt hierbei dem Manipulator beispielsweise Energie und Steuersignale zu. In einer Variante sind die beiden Maschinenteile ein Fahrzeug und eine insbesondere elektrische Ladestation und die Versorgungsleitung ist ein Ladekabel, zur Übertragung elektrischer Energie zu einem Energiespeicher des Fahrzeugs.

Allgemein sind die beiden Maschinenteile derart zueinander beweglich, dass eine Torsion, d.h. Verdrehung der Versorgungsleitung erfolgt oder zumindest möglich ist. Insbesondere wird die Torsion im Rahmen einer online-Überwachung kontinuierlich oder in regelmäßigen Zeitabständen gemessen. Auf Grundlage und abhängig von der gemessenen Torsion wird dann beispielsweise ein Warnsignal ausgegeben, falls die Versorgungsleitung über ein vorgegebenes Limit hinaus verdreht wird. Alternativ oder zusätzlich wird die gemessene Torsion zur Verschleißprognose verwendet, d.h. die Torsion wird regelmäßig gemessen und insbesondere in einem Speicher der Messeinheit speichert, um den tatsächlichen Gebrauch und damit den Verschleiß der Versorgungsleitung zu überwachen.

Die Messeinheit weist zweckmäßigerweise eine geeignete Auswerteschaltung auf, um ausgehend von der gemessenen Kapazität die Torsion zu ermitteln. Sowohl analoge als auch digitale Ansätze sind hierfür geeignet. Die gemessene Kapazität wird beispielsweise über eine Tabelle in eine Torsion der Versorgungsleitung in Grad oder Umdrehungen pro Meter umgerechnet oder direkt als Wert für die Torsion verwendet.

Vorliegend weist die Sensorleitung zwei Leiter auf, welche ein Leiterpaar bilden. Der Parameter ist hierbei eine Kapazität des Leiterpaares. Dem liegt insbesondere die Erkenntnis zugrunde, dass die zwei Leiter einen Kondensator bilden, mit einer Kapazität, welche vom Abstand zwischen den beiden Leitern abhängig ist. Bei einer Torsion des Leiterpaares wird dieses entsprechend verdreht und der Abstand der Leiter verändert sich, insbesondere rücken die Leiter näher zueinander. Durch Messung der torsionsabhängigen Kapazität lässt sich auf einfache Weise die Torsion der Sensorleitung und somit der Versorgungsleitung bestimmen. Dabei müssen die Leiter nicht zwingend als Litzenleiter ausgebildet sein, sondern sind zweckmäßigerweise massive Einzeldrähte, deren individuelle Übertragungseigenschaften dann insbesondere nicht von der Torsion beeinflusst werden. Vielmehr wird eine Übertragungseigenschaft und somit ein elektrischer Parameter des Leiterpaares an sich gemessen.

Die beiden Leiter bilden allgemein ein Übertragungspaar für ein Sensorsignal. Allgemein sind die Leiter jeweils von einem Isolationsmantel umgeben und bilden jeweils beispielsweise eine Ader aus. Im Hinblick auf eine möglichst ungestörte Übertragung der Sensorsignale ist das Übertragungspaar geeignet zueinander angeordnet. Das Übertragungspaar kann allgemein als verdrilltes Paar ausgebildet sein sowie mit oder ohne Paarschirmung.

Bei Verwendung zweier paralleler Leiter ändert sich die Kapazität prinzipbedingt in beiden Torsionsrichtungen gleichermaßen. Vorliegend wird daher zur Bestimmung der Richtung der Torsion das Leiterpaar bei der Herstellung verseilt, sodass auch ein Aufdrehen und somit eine Vergrößerung des Abstands möglich ist. Je nach Richtung der Torsion wird dann der Abstand vergrößert oder verringert.

Die Messeinheit ist zur Messung der Kapazität zweckmäßigerweise als Kapazitätsmesseinheit ausgebildet. Beispielsweise stellt die Messeinheit über einen zweipoligen Anschluss als Testsignal eine Wechselspannung bereit, welche an das Leiterpaar angelegt wird. Durch Messung des Antwortverhaltens des Leiterpaares wird dann die Kapazität bestimmt. Die Bestimmung der Torsion wiederum erfolgt dann beispielsweise durch eine Zuordnung mittels einer hinterlegten Tabelle. Als Testsignal eignen sich insbesondere Signale mit einer Frequenz im Bereich von 0 bis 100 kHz.

Um insbesondere eine geeignete Deformation der Sensorleitung und eine Abstandsveränderung der Leiter bei der Torsion zu ermöglichen, ist zwischen den beiden Leitern ein weiches Material angeordnet, welches bei einer Torsion des Kabels komprimiert oder aufgeweitet wird. Als Material eignen sich hier besonders geschäumte Kunststoffe. Beispielsweise weist die Sensorleitung ein Profil oder Profilelement auf, in welches die Leiter eingebettet sind, wobei das Profilelement ein Kernelement aufweist, welches dann zwischen den beiden Leitern angeordnet ist. Zumindest das Kernelement ist dann aus dem weichen Material gefertigt. Das Profil ist beispielsweise in etwa H-förmig oder doppel-V-förmig.

In einer geeigneten Ausgestaltung weist das weiche Material eine Shore-A-Härte im Bereich von 10 bis 30 auf. Konkret hängt die optimale Härte jedoch den Abmessungen der Sensorleitung ab. Beispielsweise ist ein flexibler Schaum, z.B. aus PUR geeignet. In jedem Fall ist das Material vorzugsweise derart gewählt, dass eine durch eine Torsion verursachte Geometrieänderung reversibel ist. Ein solches Material ist hinreichend weich, um bei einer Torsion eine geeignete Abstandsänderung der Leiter zueinander zu gewährleisten.

Die beiden Leiter sind zweckmäßigerweise gemeinsam in ein Profil aus einem isolierenden Material eingebettet und mittels des Profils zueinander beabstandet. Das isolierende Material bildet insbesondere zugleich eine gemeinsame Ummantelung oder einen Leitungsmantel der beiden Leiter. Als Material eignen sich vor allem Kunststoffe, beispielsweise PE, PP, PVC oder PA. Der oben genannte Steg aus weichem Material ist zweckmäßigerweise durch das Profil ausgebildet und dann insbesondere ein Bestandteil desselben.

In einer vorteilhaften Ausgestaltung sind die beiden Leiter jeweils als Koaxialleiter ausgebildet, d.h. individuell mit einem Dielektrikum und einer Schirmung versehen. Dadurch sind die Übertragungseigenschaften definierter und Störeinflüsse aus der Umgebung werden wirkungsvoll abgeschirmt.

Um insbesondere die Leiter insgesamt vor Umwelteinflüssen, vor allem elektrischen Störungen zu schützen, sind in einer geeigneten Ausgestaltung beide Leiter von einer gemeinsamen Schirmung umgeben. Dadurch sind die Leiter der Sensorleitung vorteilhaft auch in einem Gesamtverbund mit der Versorgungsleitung gegenüber anderen Leitern der Versorgungsleitung abgeschirmt.

Für die Ausgestaltung der Sensorleitung kann allgemein - unter Berücksichtigung der vorhergehenden Anforderungen für die gewünschte Auswertung der Torsionsbelastung - auf übliche Ausgestaltungen bei Datenleitungen zurückgegriffen werden. Auch kann die Sensorleitung in einen (Daten-)Leitungsverbund, beispielsweise einen (Vierer-) Verseilverbund integriert sein. Darüber hinaus besteht auch die Möglichkeit, die Sensorleitung auch für eine zusätzliche Datenübertragung und / oder Übertragung einer Versorgungsspannung bzw. einer elektrischen Leistung heranzuziehen. Im letztgenannten Fall wird das Sensorsignal beispielsweise aufmoduliert.

Nachfolgend werden Ausführungsbeispiele der Erfindung anhand einer Zeichnung näher erläutert. Darin zeigen jeweils schematisch:

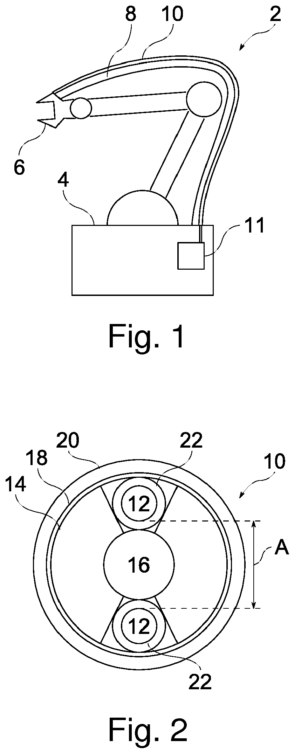

Fig. 1 eine Vorrichtung, mit einer Versorgungsleitung und einer Sensorleitung und Fig. 2 eine Sensorleitung.

In Fig. 1 ist eine Vorrichtung 2 gezeigt, die hier ein Roboter ist. Die Vorrichtung 2 weist zwei Maschinenteile 4, 6 auf, hier eine Basis 4 und einen Manipulator 6. Die Maschinenteile 4, 6 sind mittels einer Versorgungsleitung 8 miteinander verbunden. Diese weist zur Übertragung von Energie, Daten, Signalen und/oder Arbeitsmedien üblicherweise mehrere, insbesondere unterschiedliche Arten von hier nicht näher dargestellten Versorgungssträngen in Form von elektrischen, hydraulischen oder pneumatischen Leitungen etc. auf. In Fig. 1 werden mittels der Versorgungsleitung 8 beispielsweise Steuersignale von der Basis 4 zum Manipulator 6 übertragen. In einer nicht gezeigten Variante sind die beiden Maschinenteile 4, 6 beispielsweise ein Fahrzeug und eine elektrische Ladestation und die Versorgungsleitung 8 ist ein Ladekabel, zum Laden eines Energiespeichers des Fahrzeugs.

Die Maschinenteile 4, 6 sind zueinander beweglich und entsprechend soll auch die Versorgungsleitung 8 möglichst flexibel beweglich sein. Dadurch ergeben sich unter Umständen komplexe mechanische Belastungen der Versorgungsleitung 8, besonders auch eine Torsion, d.h. Verdrehung. Die Torsion der Versorgungsleitung 8 wird mittels einer Sensorleitung 10 bestimmt, welche Teil der Versorgungsleitung 8 ist und dadurch mit den Versorgungssträngen mechanisch gekoppelt ist. Die Sensorleitung 10 wird im Falle einer Torsion der Versorgungsleitung 8 entsprechend ebenfalls verdreht. Die Sensorleitung 10 ist vorzugsweise zusammen mit den weiteren Versorgungssträngen von einem gemeinsamen Außenmantel der Versorgungsleitung 8 umgeben oder alternativ auch außen an einem solchen Außenmantel oder auch an einem Versorgungsstrang angebracht.

Die Sensorleitung 10 dient selbst als Sensor, nämlich als Torsionssensor, sodass sich zwischen den beiden Maschinenteilen 4, 6 eine Torsion nicht lediglich punktuell sondern entlang der gesamten Versorgungsleitung 8 bestimmen lässt. Die Sensorleitung 10 weist Übertragungseigenschaften auf, welche von einer Torsion der Sensorleitung 10 abhängig sind. Diese Übertragungseigenschaften sind durch zumindest einen elektrischen Parameter charakterisiert, welcher mittels einer Messeinheit 11 gemessen wird. Hierzu wird mittels der Messeinheit 11 ein Testsignal in die Sensorleitung 10 eingespeist und insbesondere die Änderung des Testsignals aufgrund veränderter Übertragungseigenschaften untersucht.

Ein Ausführungsbeispiel der Sensorleitung 10 ist in Fig. 2 im Querschnitt senkrecht zur Längsrichtung der Sensorleitung 10 dargestellt. Diese weist zwei Leiter 12 auf, mittels welcher die Messung der Torsion erfolgt. Die beiden Leiter 12 sind in einem Abstand A voneinander beabstandet. Bei einer Torsion der Sensorleitung 10 werden die beiden Leiter 12 gegeneinander verdreht und der Abstand A verändert sich. Vorliegend sind die beiden Leiter 12 in einer Ausgangslage bereits miteinander verseilt, sodass eine Torsion in einer Richtung eine Abstandsverringerung bewirkt und eine Torsion in anderer Richtung eine Abstandsvergrößerung. Die beiden Leiter 12 sind in ein Profil 14 eingebettet, welches ein Kernelement 16 aufweist. Das Kernelement 16 ist zwischen den Leitern 12 angeordnet und gibt den Abstand A vor. Um eine Änderung des Abstands A zu ermöglichen ist das Kernelement 16 aus einem weichen und somit verformbaren Material gefertigt. Dadurch lässt sich das Kernelement 16 komprimieren oder auseinanderziehen.

Die Torsionsmessung beruht auf der Erkenntnis, dass die beiden Leiter 12 einen Kondensator bilden, mit einer Kapazität, welche vom Abstand A und somit von der Torsion abhängig ist. Entsprechend ist dann die Messeinheit 11 zweckmäßigerweise als Kapazitätsmesseinheit ausgebildet und misst als elektrischen Parameter die Kapazität des Leiterpaares. Mithilfe der gemessenen Kapazität wird dann die Torsion bestimmt.

Die Sensorleitung 10 der Fig. 2 weist zusätzlich eine Schirmung 18 auf, welche die beiden Leiter 12 umgibt und gegen Störeinflüsse von außen abschirmt. Um die Schirmung 18 herum ist ein Leitungsmantel 20 angeordnet. Die Leiter 12 sind jeweils von einem Isoliermantel 22 umgeben. In einer nicht gezeigten Variante sind die Leiter 12 nicht jeweils von einem Isoliermantel 22 umgeben. In einer ebenfalls nicht gezeigten Variante sind die beiden Leiter 12 als Koaxialleiter ausgebildet und weisen dann alternativ oder zusätzlich zur Schirmung 18 jeweils eine eigene Schirmung auf.

## Patentansprüche

1. Vorrichtung (2) mit zwei Maschinenteilen (4, 6), welche relativ zueinander beweglich sind und welche mittels einer Versorgungsleitung (8) miteinander verbunden sind, und mit einer Messeinheit (11),
- wobei die Versorgungsleitung (8) eine Sensorleitung (10) zur Messung der Torsion der Versorgungsleitung (8) aufweist, und
- wobei die Sensorleitung (10) zwei Leiter (12) aufweist, welche ein Leiterpaar bilden, mit einer Kapazität, welche vom Abstand (A) zwischen den beiden Leitern (12) abhängig ist,
- wobei, um eine Abstandsveränderung der Leiter (12) bei der Torsion zu ermöglichen, zwischen den beiden Leitern (12) ein weiches Material (16) angeordnet ist, welches bei der Torsion komprimiert oder aufgeweitet wird,
- wobei zur Bestimmung der Richtung der Torsion das Leiterpaar verseilt hergestellt ist und dann je nach Richtung der Torsion der Abstand (A) vergrößert oder verringert wird,
- wobei die Sensorleitung (10) an die Messeinheit (11) angeschlossen ist, welche derart ausgebildet ist, dass die Kapazität der Sensorleitung (10) gemessen wird und dass mittels der Kapazität auf die Torsion geschlossen wird.

2. Vorrichtung (2) nach Anspruch 1,
**dadurch gekennzeichnet,**
**dass** das weiche Material (16) eine Shore-A-Härte im Bereich von 10 bis 30 aufweist.

3. Vorrichtung (2) nach einem der Ansprüche 1 bis 2,
**dadurch gekennzeichnet,**
**dass** die beiden Leiter (12) gemeinsam in ein Profil (14) aus einem isolierenden Material eingebettet sind und mittels diesem zueinander beabstandet sind.

4. Vorrichtung (2) nach einem der Ansprüche 1 bis 3,
**dadurch gekennzeichnet,**
**dass** die beiden Leiter (12) jeweils als Koaxialleiter ausgebildet sind.

5. Vorrichtung (2) nach einem der Ansprüche 1 bis 4,
**dadurch gekennzeichnet,**
**dass** die beiden Leiter (12) von einer gemeinsamen Schirmung (18) umgeben sind.

6. Verfahren zur Messung der Torsion einer Versorgungsleitung (8) einer Vorrichtung (2) gemäß einem der Ansprüche 1 bis 5,
- wobei die Messeinheit (11) ein elektrisches Testsignal bereitstellt,
- wobei zur Messung der Kapazität das elektrische Testsignal an die Sensorleitung (10) angelegt oder in diese eingespeist wird und durch Messung des Antwortverhaltens dann die Kapazität des Leiterpaares bestimmt wird,
- wobei die Messeinheit (11) mit der Messung der Kapazität dann die Torsion der Sensorleitung (10) bestimmt und damit auch die Torsion der Versorgungsleitung (8).

7. Verwendung einer Sensorleitung (10) zur Messung einer Torsion,
- wobei die Sensorleitung (10) zwei Leiter (12) aufweist, welche ein Leiterpaar bilden, mit einer Kapazität, welche vom Abstand (A) zwischen den beiden Leitern (12) abhängig ist,
- wobei, um eine Abstandsveränderung der Leiter (12) bei der Torsion zu ermöglichen, zwischen den beiden Leitern (12) ein weiches Material (16) angeordnet ist, welches bei der Torsion komprimiert oder aufgeweitet wird,
- wobei zur Bestimmung der Richtung der Torsion das Leiterpaar verseilt hergestellt ist und dann je nach Richtung der Torsion der Abstand (A) vergrößert oder verringert wird,
- wobei die Sensorleitung (10) an eine Messeinheit (11) angeschlossen ist, welche ein elektrisches Testsignal bereitstellt,
- wobei zur Messung der Kapazität das elektrische Testsignal an die Sensorleitung (10) angelegt oder in diese eingespeist wird und durch Messung des Antwortverhaltens dann die Kapazität des Leiterpaares bestimmt wird,
- wobei die Messeinheit (11) mit der Messung der Kapazität dann die Torsion der Sensorleitung (10) bestimmt.

## Claims

1. Device (2) with two machine parts (4, 6), which are movable relative to each other and which are connected to each other by means of a supply line (8), and with a measuring unit (11)
- wherein the supply line (8) comprises a sensor line (10) for measuring the torsion of the supply line (8), and
- wherein the sensor line (10) comprises two conductors (12), which form a conductor pair, with a capacitance which is dependent on the distance (A) between the two conductors (12),
- wherein, to enable the distance between the conductors (12) to be changed during torsion, a soft material (16) is arranged between the two conductors (12), which is compressed or expanded during torsion,
- wherein, to determine the direction of the torsion, the conductor pair is stranded and then, depending on the direction of the torsion, the distance (A) is increased or reduced,
- wherein the sensor cable (10) is connected to the measuring unit (11), which is designed in such a way that the capacitance of the sensor cable (10) is measured and that the torsion is inferred by means of the capacitance.

2. Device (2) according to claim 1,
**characterized in**
**that** the soft material (16) has a Shore A hardness in the range from 10 to 30.

3. Device (2) according to claim 1 or 2,
**characterized in**
**that** the two conductors (12) are embedded together in a profile (14) of an insulating material and are spaced apart from one another by means of said profile.

4. Device (2) according to one of claims 1 to 3,
**characterized in**
**that** the two conductors (12) are respectively designed as coaxial conductors.

5. Device (2) according to one of claims 1 to 4,
**characterized in**
**that** the two conductors (12) are surrounded by a common shield (18).

6. Method for measuring the torsion of a supply line (8) of a device (2) according to one of claims 1 to 5,
- wherein the measuring unit (11) provides an electrical test signal,
- wherein, for measuring the capacitance, the electrical test signal is applied to or fed into the sensor line (10) and the capacitance of the conductor pair is then determined by measuring the response behaviour,
- wherein the measuring unit (11) then determines the torsion of the sensor cable (10) with the measurement of the capacitance and thus also the torsion of the supply cable (8).

7. Using a sensor cable (10) for measuring a torsion,
- wherein the sensor line (10) comprises two conductors (12), which form a conductor pair, with a capacitance which is dependent on the distance (A) between the two conductors,
- wherein, to enable the distance between the conductors to be changed during torsion, a soft material (16) is arranged between the two conductors (12), which is compressed or expanded during torsion,
- wherein, to determine the direction of the torsion, the conductor pair is stranded and then, depending on the direction of the torsion, the distance (A) is increased or reduced,
- wherein the sensor cable (10) is connected to a measuring unit (11), which provides an electrical test signal,
- wherein, for measuring the capacitance, the electrical test signal is applied to or fed into the sensor line (10) and the capacitance of the conductor pair is then determined by measuring the response behaviour,
- wherein upon measuring the capacitance the measuring unit (11) then determines the torsion of the sensor cable.

## Revendications

1. Dispositif (2) avec deux parties de machine (4, 6) mobiles l'une par rapport à l'autre et reliées entre elles par une ligne d'alimentation (8), et avec une unité de mesure (11)
- dans lequel la conduite d'alimentation (8) comporte une ligne de capteur (10) pour mesurer la torsion de la conduite d'alimentation (8), et
- dans lequel la ligne de capteur (10) comporte deux conducteurs (12), qui forment une paire de conducteurs, avec une capacité qui dépend de la distance (A) entre les deux conducteurs (12),
- dans lequel, afin permettre une modification de la distance des conducteurs (12) pendant la torsion, un matériau souple (16) est disposé entre les deux conducteurs (12), qui est comprimé ou élargi pendant la torsion,
- dans lequel la paire de conducteurs est toronnée pour déterminer la direction de la torsion et ensuite la distance (A) est augmentée ou réduite en fonction de la direction de la torsion,
- dans lequel le câble de capteur (10) est relié l'unité de mesure (11), qui est conçue de telle manière que la capacité du câble de capteur (10) est mesurée et que la torsion est déduite au moyen de la capacité.

2. Dispositif (2) selon la revendication précédente,
**caractérisé en ce**
**que** le matériau souple (16) a une dureté Shore A comprise entre 10 et 30.

3. Dispositif (2) selon l'une des revendications précédentes,
**caractérisé en ce**
**que** les deux conducteurs (12) sont intégrés ensemble dans un profilé (14) d'un matériau isolant et sont espacés l'un de l'autre au moyen dudit profilé.

4. Dispositif (2) selon l'une des revendications 1 à 3,
**caractérisé en ce**
**que** les deux conducteurs (12) sont conçus respectivement comme des conducteurs coaxiaux.

5. Dispositif (2) selon l'une des revendications 1 à 4,
**caractérisé en ce**
**que** les deux conducteurs (12) sont entourés par un blindage commun (18).

6. Procédé pour mesurer la torsion d'une ligne d'alimentation (8) d'un dispositif (2) selon l'une des revendications 1 à 5,
- dans lequel l'unité de mesure (11) fournit un signal de test électrique,
- dans lequel, pour mesurer la capacité, le signal électrique de test est appliqué ou introduit dans la ligne de capteur (10) et la capacité de la paire de conducteurs est ensuite déterminée en mesurant le comportement de réponse,
- dans lequel l'unité de mesure (11) avec la mesure de la capacité détermine ensuite la torsion du câble du capteur (10) et donc également la torsion du câble d'alimentation (8).

7. Utilisation d'un câble de capteur (10) pour mesurer une torsion,
- dans laquelle la ligne de capteur (10) comporte deux conducteurs (12), qui forment une paire de conducteurs, avec une capacité qui dépend de la distance (A) entre les deux conducteurs,
- dans laquelle, afin de permettre de modifier la distance entre les conducteurs pendant la torsion, un matériau souple (16) est disposé entre les deux conducteurs (12), qui est comprimé ou élargi pendant la torsion,
- dans laquelle la paire de conducteurs est toronnée pour déterminer la direction de la torsion et, ensuite, la distance (A) est augmentée et réduite en fonction de la direction de la torsion,
- dans laquelle le câble du capteur (10) est connecté à une unité de mesure (11), qui fournit un signal de test électrique,
- dans laquelle, pour mesurer la capacité, le signal électrique de test est appliqué ou introduit dans la ligne de capteur (10) et la capacité de la paire de conducteurs est ensuite déterminée en mesurant le comportement de réponse,
- dans laquelle l'unité de mesure (11) détermine ensuite la torsion du câble du capteur en mesurant la capacité.
